# EUROPEAN PATENT APPLICATION

(11) **EP 2 523 250 A1**
(43) Date of publication of application: **14.11.2012**
(21) Application number: 10842201.5
(22) Date of filing: 22.12.2010
(51) Int. Cl.: H01M 14/00, H01L 31/04

(54) **METHOD FOR MANUFACTURING DYE-SENSITIZED SOLAR CELL**

(30) Priority: 08.01.2010 JP 2010002440
(71) Applicant: Hitachi Zosen Corporation, Osaka-shi, Osaka 559-8559 (JP)
(72) Inventor: SUGIYO, Takeshi, Osaka-shi Osaka 559-8559 (JP); INOUE, Tetsuya, Osaka-shi Osaka 559-8559 (JP)
(74) Representative: Engelhardt, Harald
(86) International application number: PCT/JP2010/073082
(87) International publication number: WO 2011/083688

(57) **Abstract**

Disclosed is a method for manufacturing a dye-sensitized solar cell including a transparent electrode (1), a counter electrode (2), an electrolyte layer (3) disposed between the electrodes (1) and (2), and a photocatalyst film (4) disposed between the electrodes (1) and (2) and near the transparent electrode (1), the method including: forming the photocatalyst film (4) by applying a mixed solution to a surface of the transparent electrode (1) and sintering the mixed solution by laser beam irradiation, the mixed solution containing fine particles of titanium oxide serving as photocatalyst fine particles and a solution of titanium isopropoxide serving as a photocatalyst precursor.

## Description

### Technical Field

The present invention relates to a method for manufacturing a dye-sensitized solar cell.

### Background Art

Generally, a dye-sensitized solar cell includes: a transparent electrode including a transparent conductive film formed on a transparent substrate, e.g., a glass plate; a counter electrode including a similar transparent conductive film formed on the surface of a transparent substrate; an iodized electrolyte layer disposed between the electrodes; and a photocatalyst film disposed between the electrodes and on the surface of the transparent electrode. A known photocatalyst film contains a metallic oxide such as titanium oxide (TiO₂) and is stained with a photosensitizing dye such as ruthenium.

Fine particles of titanium oxide are used as the photocatalyst and the precursor of titanium oxide is mixed to improve characteristics (see Patent Literature 1).

### Citation List

### Patent Literature

Patent Literature 1: Japanese Patent Laid-Open No. 2004-193321

### Summary of Invention

### Technical Problem

According to Patent Literature 1, the photocatalyst is formed by applying a mixed solution of titanium oxide and the precursor of titanium oxide to the transparent electrode and then burning the overall electrode at a high temperature, e.g., about 450°C.

Unfortunately, such a high turning temperature precludes the use of a lightweight and inexpensive synthetic resin for the transparent substrate. Burning at a low temperature may lead to weak binding (necking) between fine particles of titanium oxide, deteriorating an electron path in a cell.

An object of the present invention is to provide a method for manufacturing a dye-sensitized solar cell which can use a heat-sensitive material, e.g., a synthetic resin for a substrate and prevent a reduction in binding between photocatalyst fine particles.

### Solution to Problem

In order to solve the problem, a first aspect of the present invention is a method for manufacturing a dye-sensitized solar cell including: a transparent electrode, a counter electrode, an electrolyte layer disposed between the electrodes, and a photocatalyst film disposed between the electrodes and near the transparent electrode,
the method including: forming the photocatalyst film by sintering a mixed solution by laser beam irradiation when or after applying, to the surface of the transparent electrode, the mixed solution containing fine particles of a metallic oxide serving as a photocatalyst and a solution of metal alkoxide serving as a photocatalyst precursor, metal acetylacetonate, metal carboxylate, metal nitrate, oxychloride, and chloride.

A second aspect of the present invention is a method according to the manufacturing method of the first aspect, wherein the mixed solution is applied to the transparent electrode by a spray nozzle.

A third aspect of the present invention is a method according to the manufacturing method of the first aspect, wherein the mixed solution is applied to the transparent electrode by electrostatic coating.

A fourth aspect of the present invention is a method according to the manufacturing method of any one of the first to third aspects, wherein when the photocatalyst film is formed, a laser beam is emitted from the surface coated with the mixed solution.

A fifth aspect of the present invention is a method according to the manufacturing method of any one of the first to third aspects, wherein when the photocatalyst film is formed, a laser beam is emitted from an uncoated surface opposite from the surface coated with the mixed solution.

A sixth aspect of the present invention is a method according to the manufacturing method of one of the first to third aspects, wherein when the photocatalyst film is formed, a laser beam is emitted from the surface coated with the mixed solution, and an uncoated surface opposite from the coated surface.

### Advantageous Effects of Invention

According to the manufacturing method, in the formation of the photocatalyst film on the transparent electrode, the mixed solution of the photocatalyst and the precursor of the photocatalyst is applied to the surface of the transparent electrode. After or during the application, the coating is irradiated with a laser beam and is instantly sintered. In other words, it is not necessary to heat the overall electrode. Thus, the substrate of the transparent electrode may be made of a heat-sensitive material such as a synthetic resin, reducing the weight and cost of a solar cell. Since it is not necessary to heat the overall substrate, the need for a large heater is eliminated, reducing the cost of production equipment. Moreover, photocatalyst fine particles are instantly sintered through the precursors by a laser beam, leading to stronger binding between the photocatalyst fine particles.

### Brief Description of Drawings

[FIG. 1] FIG. 1 is a cross-sectional view illustrating a dye-sensitized solar cell according to an embodiment of the present invention.
[FIG. 2] FIG. 2 is a side view for explaining an example of a method for manufacturing the dye-sensitized solar cell.

### Description of Embodiments

A method for manufacturing a dye-sensitized solar cell according to an embodiment of the present invention will be described below.

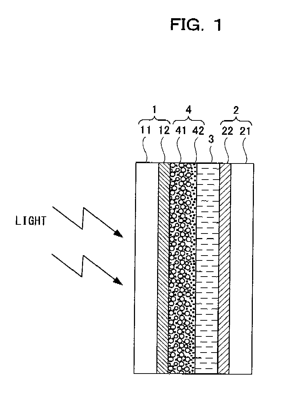

First, referring to FIG. 1, the configuration of the dye-sensitized solar cell will be schematically described according to the present embodiment.

As illustrated in FIG. 1, the dye-sensitized solar cell includes a transparent electrode 1 serving as a negative electrode, a counter electrode 2 serving as a positive electrode, an electrolyte layer 3 disposed between the electrodes 1 and 2, and a photocatalyst film (also called a photocatalyst layer) 4 disposed between the electrodes 1 and 2 and near the transparent electrode 1.

The transparent electrode 1 includes a transparent substrate 11 and a transparent conductive film 12 formed on a surface of the transparent substrate 11. The counter electrode 2 includes a transparent substrate 21 and a transparent conductive film 22 formed on a surface of the transparent substrate 21.

The transparent substrates 11 are 21 may be, for example, synthetic resin plates or glass plates. In view of a reduction in weight and cost, a film of a thermoplastic resin such as polyethylene naphthalate (PEN) is preferable. Materials including polyethylene terephthalate, polyester, polycarbonate, polyolefin can be used in addition to polyethylene naphthalate.

The transparent conductive films 12 and 22 are preferably made of indium tin oxide (ITO). The transparent conductive films 12 and 22 may be thin films containing conductive metallic oxides such as fluorine-doped tin oxide (FTO), tin oxide (SnO₂), indium zinc oxide (IZO), and zinc oxide (ZnO).

The electrolyte layer 3 is, for example, an iodine electrolyte solution. Specifically, electrolyte components such as iodine, an iodide ion, and t-butylpyridine are dissolved in an organic solvent containing, for example, ethylene carbonate and methoxyacetonitrile. The electrolyte layer 3 is not limited to an electrolyte solution and may be a solid electrolyte.

The solid electrolyte is, for example, DMPImI (dimethylpropyl imidazolium iodide). Furthermore, the solid electrolyte may be metallic iodides including LiI, NaI, KI, CsI, and CaI₂, a combination of I₂ and an iodide, e.g., an iodine salt of quaternary ammonium compounds such as tetraalkylammonium iodide, metal bromides including LiBr, NaBr, KBr, CsBr, and CaBr₂, and a combination of Br₂ and a bromide, e.g., a bromide salt of quaternary ammonium compounds such as tetraalkylammonium bromide.

The photocatalyst film 4 includes an oxide semiconductor layer 41 containing adsorbed photosensitizing dyes 42. The photocatalyst film 4 is produced by applying paste containing oxide semiconductors, which are photocatalyst fine particles, to the surface of the transparent electrode 1, drying the paste, and then adsorbing the photosensitizing dyes onto the oxide semiconductors.

The oxide semiconductors are metallic oxides including titanium oxide (TiO₂), tin oxide (SnO₂), tungsten oxide (WO₃), zinc oxide (ZnO), and niobium oxide (Nb₂O₅). The photosensitizing dyes are ruthenium complexes or iron complexes containing ligands having bipyridine structures or terpyridine structures, metal complexes of porphyrin and phthalocyanine, or organic dyes such as eosin, rhodamine, merocyanine, and coumarin.

The counter electrode 2 includes the transparent conductive film 22 formed on the surface of the transparent substrate 21. The counter electrode 2 may be a metal sheet made of, for example, aluminum, copper, and tin. Additionally, the counter electrode may contain a gel solid electrolyte that is held on a mesh electrode made of carbon or metals such as aluminum, copper, and tin. Alternatively, the counter electrode 2 may be configured such that one surface of the transparent substrate 21 is covered with a conductive adhesive layer and separately formed brush-like carbon nanotubes are transferred to the transparent substrate 21 via the adhesive layer.

A method for forming the photocatalyst film 4 on the surface of the transparent electrode 1 will be discussed below.

A mixed solution of titanium oxide serving as photocatalyst fine particles and a solution of metal alkoxide (titanium alkoxide) serving as a precursor of titanium oxide is evenly sprayed onto the surface of the transparent conductive film 12 of the transparent electrode 1 to form a coating and then the coating is sintered by laser beam irradiation (i.e., from the coated surface) to form the oxide semiconductor layer 41. The oxide semiconductor layer 41 is dipped into an immersion liquid containing the photosensitizing dyes 42 to adsorb the dyes and then the oxide semiconductor layer 41 is dried. Preferably, the oxide semiconductor layer 41 is burned after that.

Instant sintering with a laser beam can prevent the overall transparent electrode 1 from rising in temperature. In other words, the overall substrate is not heated and thus may be made of heat-sensitive materials such as a synthetic resin (plastic).

In an assembly operation for the dye-sensitized solar cell (photoelectric conversion element), the transparent electrode 1 on which the photocatalyst film 4 is formed is aligned with the counter electrode 2 and then a space between the electrodes 1 and 2 is sealed with a thermal adhesive film or a sealer. A liquid electrolyte may be injected into the space between the electrodes 1 and 2 from a hole or a gap in advance formed on the transparent electrode 1 or the counter electrode 2.

In the case of a solid electrolyte, the outer edges of the electrodes 1 and 2 may be thermally bonded to each other after the electrodes 1 and 2 are stacked with the photocatalyst film 4 and the electrolyte layer 3 interposed between the electrodes 1 and 2. The electrodes 1 and 2 may be heated by dies or irradiation of energy beams, e.g., plasma (long wavelength), microwaves, visible light (at least 600 nm), and infrared rays.

According to the method for manufacturing the dye-sensitized solar cell, in the formation of the photocatalyst film on the transparent electrode, the mixed solution of the photocatalyst and the precursor of the photocatalyst is applied to the surface of the transparent electrode by a spray nozzle (i.e., by spraying). After or during the application, the coating is instantly heated and sintered by laser beam irradiation. In other words, it is not necessary to heat the overall electrode. Thus, the substrate of the transparent electrode may be made of a heat-sensitive material such as a synthetic resin. Since it is not necessary to heat the overall substrate, the need for a large heater is eliminated, reducing the cost of production equipment.

In other words, conventionally, a transparent substrate made of a synthetic resin in a transparent electrode needs to be burned at a low temperature. Unfortunately, burning at a low temperature leads to weak binding (necking) between fine particles of titanium oxide, deteriorating an electron path in a cell. The use of a laser beam does not reduce binding between fine particles of titanium oxide and binding between the photocatalyst film, that is, the photocatalyst layer and the transparent electrode, preventing deterioration of an electron path in a cell.

### First Example

A method for forming the dye-sensitized solar cell will be discussed according to a first example, which will specifically describe the present embodiment.

In the first example, first, a mixed solution of a photocatalyst fine particles and a solution of the photocatalyst precursor was applied to a commercial PEN-ITO film by electrostatic spraying to form the oxide semiconductor layer 41.

The mixed solution to be applied (hereinafter, will be also called an applied solution) was prepared by agitating and mixing photocatalyst fine particles that are 20-nm fine particles of titanium oxide (Nippon Aerosil Co., Ltd., P-25) and a photocatalyst precursor solution that is a mixed solution of 0.20 g of titanium (IV) isopropoxide (TTIP) and 37.50 g of propanol.

The oxide semiconductor layer 41 was then dipped into an immersion liquid containing the photosensitizing dyes 42 to adsorb the dyes, forming the photocatalyst film 4.

A ruthenium complex (N719, a molecular weight of 1187.7 g/mol) was dissolved in a mixed solution of t-butanol and acetonitrile (volume ratio 1:1) to prepare the immersion solution containing the photosensitizing dyes (dye concentration: 0.3 mM). The oxide semiconductor layer 41 was dipped into the immersion solution at 40°C for 40 minutes to adsorb the dyes.

Electrostatic spraying will be simply described below.

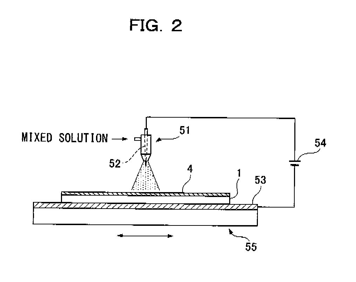

As illustrated in FIG. 2, in the electrostatic spraying method, a needle electrode 52 is disposed at the center of a spray nozzle 51 that sprays a solution to the transparent electrode 1, a direct-current power supply 54 having a predetermined voltage is connected between the needle electrode 52 and an application electrode 53 on which the transparent electrode 1 is placed, a positive voltage is applied to the needle electrode 52 during spraying to electrically charge a spray liquid, and the liquid is sprayed and attached to a surface of the transparent electrode 1 placed on the negative application electrode 53. The transparent electrode 1 is placed on a horizontally moving device 55 and can move to any position.

The application conditions of electrostatic spraying include the type of spray nozzle, the viscosity of the applied solution, an atomization air pressure, a pattern width, a discharge amount, a discharge pressure, the travel speed of the nozzle, the width of deposition, a distance between the spray nozzle and the transparent electrode, and an applied voltage. These conditions vary among used devices and thus are optionally selected to have a desired thickness.

In the first example, for example, a two-fluid spray nozzle was used. The spray nozzle had an atomization air pressure of 0.2 MPa, a discharge amount of 15 g/min, a distance of 20 cm from the transparent electrode to the spray nozzle, an applied voltage of 20 kV, and a travel speed of the spray nozzle of 100 m/min.

After a coating was formed by spraying, the coating was heated at 150°C for 15 minutes and then was sintered by a YAG laser to obtain an oxide semiconductor layer having a thickness of about 5 µm to 6 µm.

The materials of the applied solution are not limited. For example, metal alkoxide serving as a photocatalyst precursor may be titanium tetramethoxide, titanium ethoxide, and titanium butoxide, metal acetylacetonate may be titanium acetylacetonate, and metal carboxylate may be titanium carboxylate. Furthermore, titanium nitrate, titanium oxychloride, and titanium tetrachloride are usable.

The photocatalyst fine particles are not limited to titanium oxide and may be zinc oxide, niobium oxide, and tungsten oxide.

A solvent for the photocatalyst precursor is not limited to propanol. For example, tert-butyl alcohol, ethoxyethanol, and ethanol are usable.

Moreover, diethanolamine and acetylacetone may be added to suppress hydrolysis.

The used laser beam will be discussed below.

Laser beams from the visible region to the near infrared region (700 nm to 1100 nm) are used. Specifically, a Nd:YAG laser (1064 nm) and a Nd:YVO4 laser (1064 nm) or wavelength tunable lasers such as a titanium sapphire laser (650 nm to 1100 nm), a Cr:LiSAF laser (780 nm to 1010 nm), and an alexandrite laser (700 nm to 820 nm) may be used.

An irradiator (not shown) for the laser beam includes a galvano scanner and can freely change a laser irradiation position.

### Second Example

A method for manufacturing the dye-sensitized solar cell according to a second example will be described below.

In the second example, the dye-sensitized solar cell according to the second example is manufactured by electrostatic spraying as in the first example. During the application of the mixed solution of photocatalyst fine particles and the precursor solution, the applied solution, that is, the coating of the transparent electrode is irradiated with a laser beam.

Thus, the solution can be applied, dried, and sintered at the same time and the crystallization of titanium oxide is accelerated.

One or both of the front side (coated surface) and the back side (uncoated surface) of the transparent electrode can be irradiated with a laser beam. Particularly, laser beam irradiation from the back side of the transparent electrode can improve binding (necking) between the transparent electrode and photocatalyst fine particles.

For example, in the case where the photocatalyst precursor is not mixed with photocatalyst fine particles and only titanium oxide fine particles and ethanol are applied by electrostatic spraying to produce the dye-sensitized solar cell, the dye-sensitized solar cell had a current density of 4.20 mA/cm², an open-circuit voltage of 0.72 V, a fill factor of 0.61, and conversion efficiency of 1.86%. In the case where a mixed solution of a photocatalyst precursor solution and photocatalyst fine particles is applied by electrostatic spraying, the dye-sensitized solar cell had a current density of 5.06 mA/cm², an open-circuit voltage of 0.75 V, a fill factor of 0.66, and conversion efficiency of 2.50%.

In other words, the mixing of photocatalyst particles with the photocatalyst precursor considerably improved cell characteristics as compared with the case where photocatalyst particles are not mixed with the photocatalyst precursor.

## Claims

1. A method for manufacturing a dye-sensitized solar cell comprising: a transparent electrode, a counter electrode, an electrolyte layer disposed between the electrodes, and a photocatalyst film disposed between the electrodes and near the transparent electrode,
the method including: forming the photocatalyst film by sintering a mixed solution of photocatalyst fine particles and a photocatalyst precursor by laser beam irradiation when or after applying the mixed solution to a surface of the transparent electrode.

2. The method for manufacturing a dye-sensitized solar cell according to claim 1, wherein the mixed solution is applied to the transparent electrode by a spray nozzle.

3. The method for manufacturing a dye-sensitized solar cell according to claim 1, wherein the mixed solution is applied to the transparent electrode by electrostatic coating.

4. The method for manufacturing a dye-sensitized solar cell according to any one of claims 1 to 3, wherein when the photocatalyst film is formed, a laser beam is emitted from the surface coated with the mixed solution.

5. The method for manufacturing a dye-sensitized solar cell according to any one of claims 1 to 3, wherein when the photocatalyst film is formed, a laser beam is emitted from an uncoated surface opposite from the surface coated with the mixed solution.

6. The method for manufacturing a dye-sensitized solar cell according to any one of claims 1 to 3, wherein when the photocatalyst film is formed, a laser beam is emitted from the surface coated with the mixed solution, and an uncoated surface opposite from the coated surface.
